Europäisches Patentamt

European Patent Office

Office européen des brevets

(11) Veröffentlichungsnummer: **0 331 163**
**A1**

(12) **EUROPÄISCHE PATENTANMELDUNG**

(21) Anmeldenummer: 89103653.5

(22) Anmeldetag: 02.03.89

(51) Int. Cl.⁴: **G01R 1/073**

(30) Priorität: 04.03.88 DE 3807024
04.03.88 DE 8802890 U
29.04.88 DE 3814620

(43) Veröffentlichungstag der Anmeldung:
06.09.89 Patentblatt 89/36

(84) Benannte Vertragsstaaten:
AT CH DE FR GB IT LI NL

(71) Anmelder: Prokopp, Manfred
Am Felder 27
D-6980 Wertheim-Reicholzheim(DE)

(72) Erfinder: Prokopp, Manfred
Am Felder 27
D-6980 Wertheim-Reicholzheim(DE)

(74) Vertreter: König, Oskar, Dr. Dipl.-Phys.
Postfach 10 27 33
D-7000 Stuttgart 10(DE)

(54) **Kontaktiervorrichtung für Prüfvorrichtungen zum Prüfen von Leiterplatten oder dgl.**

(57) Kontaktiervorrichtung für Prüfeinrichtungen zum Prüfen von elektrischen oder elektronischen Prüflingen. Sie weist eine Plattenanordnung (11) aus mehreren zueinander parallelen Platten (15, 16, 17; 15, 16) auf, in die Kontaktnadeln (12) mit Gleitlagerspiel eingesetzt sind. Jeder Kontaktnadel (12) ist ein federndes, elektrisch leitendes Gegenkontaktelement (22) zugeordnet. Die Kontaktnadel (12) besteht aus einem geraden Stift (13) und einer rohrförmigen Hülse (14), die über das rückwärtige Ende des Stiftes übersteht. Die Gegenkontaktelemente (22) weisen dem Kontaktieren der ihnen zugewandten rückwärtigen Innenränder der Hülsen (14) der Kontaktnadeln (12) dienende, sich verjüngende Köpfe (33) auf.

FIG.1

# Kontaktiervorrichtung für Prüfvorrichtungen zum Prüfen von Leiterplatten oder dgl.

Die Erfindung betrifft eine Kontaktiervorrichtung für Prüfvorrichtungen zum Prüfen von elektrischen oder elektronischen Prüflingen, wie Leiterplatten oder dgl., gemäß dem Oberbegriff des Anspruches 1.

Bei einer bekannten Kontaktiervorrichtung dieser Art (EP-A-0215146) sind die Kontaktnadeln an ihren vorderen Endbereichen in Bohrungen einer vorderen Platte einer Plattenanordnung geführt, die entsprechend den zu kontaktierenden Prüfpunkten des Prüflinges angeordnet sind, wogegen diese Kontaktnadeln an Bereichen nahe ihrer rückwärtigen Enden in einer von ihnen durchdrungenen elastischen Platte festgehalten sind, damit sie aus dem Prüfadapter nicht herausfallen können. Mit ihren rückwärtigen Enden, die kegelstumpfförmig ausgebildet sind, greifen diese Kontaktnadeln in konische Bohrungen der Köpfe von federnden Gegenkontaktelementen zu ihrem elektrischen Anschluß ein. Die kegelstumpfförmigen rückwärtigen Spitzen der Kontaktnadeln sollen dabei bewirken, daß der sich in den konischen Bohrungen der Köpfe der federnden Gegenkontaktelemente im Laufe der Betriebszeit ansammelnde Schmutz, wie Abrieb usw., den elektrischen Kontakt zwischen der jeweiligen Kontaktnadel und dem Gegenkontaktelement möglichst nicht stört, denn es könnte sonst hierdurch zu störendem starken Anstieg des elektrischen Übergangswiderstandes oder sogar zu Unterbrechungen des elektrischen Kontaktes kommen. Jedoch gibt diese Ausbildung der Verbindung zwischen den Kontaktnadeln mit kegelstumpfförmigen rückwärtigen Spitzen und den Gegenkontaktelementen mit konischen Bohrungen noch keine Gewähr dafür, dass der elektrische Übergangswiderstand über längere Betriebszeiten nicht doch störend stark ansteigt oder es sogar zu elektrischen Unterbrechungen kommt, denn die konischen Bohrungen können sich je nach anfallendem Abrieb oft relativ rasch soweit mit Schmutz zusetzen, daß dennoch der elektrische Übergangswiderstand sich unkontrolliert stark erhöht und es sogar zu elektrischen Unterbrechungen kommen kann.

Sowohl durch die unkontrollierte Erhöhung des elektrischen Übergangswiderstandes und erst recht durch elektrische Unterbrechungen an diesen Kontaktstellen ergeben sich dann Fehler in der Prüfung, die die Kontaktiervorrichtung für weitere Prüfungen unbrauchbar machen. Auch gibt die Halterung der Kontaktnadeln in einer elastischen Platte unter Berücksichtigung dessen, daß die Raster bei solchen Prüfadaptern extrem klein sind, bspw. 1/10 Zoll oder oft auch noch erheblich weniger betragen, keine Gewähr, daß die Kontaktnadeln beim Kontaktieren von Prüflingen mit allen zu kontaktierenden Stellen der Prüflinge in ausreichenden elektrischen Kontakt kommen, da sie wegen der elastischen Platte nicht unabhängig voneinander federn können, weil diese für die Kontaktnadeln praktisch nur jeweils gleich große Federwege zuläßt und die zu kontaktierenden Stellen eines Prüfling oft unterschiedliche Höhenstellungen haben.

Es ist deshalb eine Aufgabe der Erfindung, eine Kontaktiervorrichtung der im Oberbegriff des Anspruches 1 genannten Art zu schaffen, bei der sich diese Nachteile auf baulich einfache, kostengünstige Weise vermeiden lassen.

Diese Aufgabe wird erfindungsgemäß durch eine Kontaktiervorrichtung gemäß Anspruch 1 gelöst.

Bei dieser Kontaktiervorrichtung kann sich jede Kontaktnadel unabhängig von den übrigen Kontaktnadeln axial bewegen. Jede Kontaktnadel kann also die volle Kraft, die beim Prüfen eines Prüflings von dem Prüfling auf sie ausgeübt wird, über ihre rohrförmige Hülse auf das sie abstützende Gegenkontaktelment übertragen. Damit ist sichere Kontaktierung aller zu kontaktierenden Prüfpunkte des jeweiligen Prüflings gewährleistet. Besonders vorteilhaft ist ferner, daß die Köpfe der den Kontaktnadeln zugeordneten Gegenkontaktelemente in die Hohlräume der Hülsen der Kontaktnadeln deren betreffenden Innenränder kontaktierend eingreifen können, wodurch selbst dann sicherer elektrischer Kontakt gewährleistet ist, wenn die Kontaktnadel nicht genau mit dem Gegenkontaktelement fluchtet, sondern bspw. schwach schräg zu ihm geneigt ist. Dies schafft auch die Möglichkeit, die Bohrungen der vorderen Platte der Plattenanordnung für die Kontaktnadeln auch abweichend von einem Raster, nach dem die Bohrungen der rückwärtigen Platte oder mindestens einer rückwärtigen Platte der Plattenanordnung gebohrt sind, entsprechend den gewünschten zu kontaktierenden Stellen einer beliebigen Sorte von Prüflingen bohren zu können. Der den Bohrungsrand einer Hülse einer Kontaktnadel kontaktierende Kopf des betreffenden Gegenkontaktelementes kann auch praktisch als Abdeckung des lichten Innenraumes, d.h. des Hohlraumes der Hülse dienen, so daß schon hierdurch kein oder kaum Schmutz in diesen Hohlraum gelangen kann. Auch kann dieser Hohlraum verhältnismäßig groß sein, indem man den Stift in dem Innenraum der Hülse in entsprechend größerem Abstand von dem rückwärtigen Ende der Hülse enden läßt, so daß sich in dem hierdurch geschaffenen Hohlraum auch entsprechend relativ viel Schmutz oder dgl. ansammeln kann, ohne daß es zu einer Verschlechterung des elektrischen Kontaktes zwischen dem Kopf des Gegenkontaktelementes und dem betreffenden Innenrand der Hülse kommt. Auch läßt sich die Verschmutzungsunempfindlichkeit, falls erforderlich, noch dadurch vergrößern, indem man die Kontaktiervorrichtung so anordnet, daß der Hohlraum der Hülse nach unten und nicht nach oben offen ist. Auch ist die Verschmutzungsunempfindlichkeit schon deswegen gegeben, weil die Öffnung oder Mündung des Hohlraumes jeder Hülse einer Kontaktnadel nicht auf die Platten der Plattenanordnung zu gerichtet ist, an denen elektrisch isolierender Abrieb entsteht, sondern auf die Gegenkontaktelemente zu, an denen höchstens metallischer, also elektrisch leitender Abrieb in sogar höchstens unbedeutendem Maße entstehen kann.

Durch die Erfindung lässt sich also auf einfache Weise sicherstellen, daß durch beim Prüfen von Prüflingen entstehenden Abrieb die elektrischen Übergangswiderstände zwischen den Kontaktnadeln und den Gegenkontaktelementen auch über sehr lange Betriebszeit hinweg nicht durch Schmutz störend vergrößert werden oder es sogar zu elektrischen Unterbrechungen kommen kann. Dabei wird dies noch zusammen mit dem weiteren wichtigen Vorteil erreicht, daß sich die von den Gegenkontaktelementen auf die Kontaktnadeln beim Prüfen von Prüflingen ausgeübten Kräfte praktisch voll auf die zu kontaktierenden Stellen des Prüflinges übertragen können, so daß sichere Kontaktierung aller zu kontaktierenden Stellen des jeweiligen Prüflinges ohne weiteres erreicht werden kann. Darüberhinaus kann diese Kontaktiervorrichtung, die man auch als Prüfadapter bezeichnen kann, stets so ausgebildet werden, daß sie in beliebigen Stellungen ohne Gefahr des Herausfallens von Kontaktnadeln einsetzbar ist.

All dies läßt sich auf äußerst einfache und kostengünstige Weise durch die Anordnung der Hülsen an den rückwärtigen Endbereichen der Stifte der Kontaktnadeln und Ausbildung der Gegenkontaktelemente mit sich in Richtung auf die Hülsen der Kontaktnadeln zu verjüngenden Köpfen erreichen.

Die Hülsen der Kontaktnadeln können in manchen Fällen zylindrisch, vorzugsweise kreiszylindrisch sein. Bevorzugt können sie je einen Ringflansch als Verbreiterung aufweisen. Die Verbreiterung kann auch andere Gestalt aufweisen, bspw. durch einen oder mehrere seitliche Vorsprünge gebildet sein.

Bevorzugt kann der Kopf des Gegenkontaktelementes mit mehreren scharfen, vorzugsweise entlang von Kegelmantellinien eines geometrischen, zur Längsachse des Kopfes koaxialen Kegels verlaufenden, geschliffenen Kanten versehen sein, da hierdurch der elektrische Übergangswiderstand zwischen den Hülsen und den Gegenkontaktelementen besonders gering gehalten werden kann, auch unter ungünstigen Umständen und über praktisch unbegrenzt lange Betriebszeiten hinweg. Jedoch können die Köpfe der Gegenkontaktelemente oft auch konisch oder kegelstumpfförmig oder sonstige geeignete Ausbildung mit oder ohne scharfe äußere Kanten haben. Der von dem Kopf eines Gegenkontaktelementes kontaktierte Innenrand der Wandung der Hülse an ihrer dem Gegenkontaktelement benachbarten Öffnung kann ebenfalls vorzugsweise scharfkantig ausgebildet sein, doch ist dies, obwohl besonders vorteilhaft, nicht unbedingt erforderlich, zumindest nicht in vielen Fällen.

Das Gegenkontaktelement kann vorzugsweise als Federkontaktstift ausgebildet sein. Doch kann es auch andere geeignete Ausbildung aufweisen, bspw. einen den Kopf aufweisenden, in einer Bohrung einer Platte der Haltevorrichtung geradegeführten, durch Federmittel abgestützten und gehaltenen Kontakt aufweisen.

Die erfindungsgemäße Kontaktiervorrichtung ermöglicht auch einfaches Einsetzen der Kontaktnadeln in die Bohrungen der Platten der Plattenanordnung selbst dann, wenn, was im allgemeinen der Fall ist, nicht alle Bohrungen der vorderen Platte der Plattenanordnung an Rasterpunkten eines vorbestimmten Rasters angeordnet sind, wogegen die Bohrungen der rückwärtigen Platte oder mindestens einer der rückwärtigen Platten der Plattenanordnung an Rasterpunkten eines vorbestimmten Rasters angeordnet sind. Und zwar kann das Bestücken der Platten der Plattenanordnung mit Kontaktnadeln hierzu zweckmäßig gemäß dem Verfahren nach Anspruch 13 vorgenommen werden. Wenn sie zwei rückwärtige Platten aufweist, kann dieses Verfahren vorteilhaft noch gemäß Anspruch 14 weitergebildet sein.

In der Zeichnung sind Ausführungsbeispiele der Erfindung dargestellt. Es zeigen:

Fig. 1 eine gebrochene und teilweise geschnittene Seitenansicht einer Kontaktiervorrichtung gemäß einem Ausführungsbeispiel der Erfindung,

Fig. 2 eine Variante eines Kopfes eines Gegenkontaktelementes,

Fig. 3 und 4 je eine Abwandlung der Kontaktiervorrichtung nach Fig. 1 in entsprechend gebrochener und teilweise geschnittener Seitenansicht, wobei hier die Plattenanordnung jeweils nur insgesamt zwei Platten für die Kontaktnadeln aufweist.

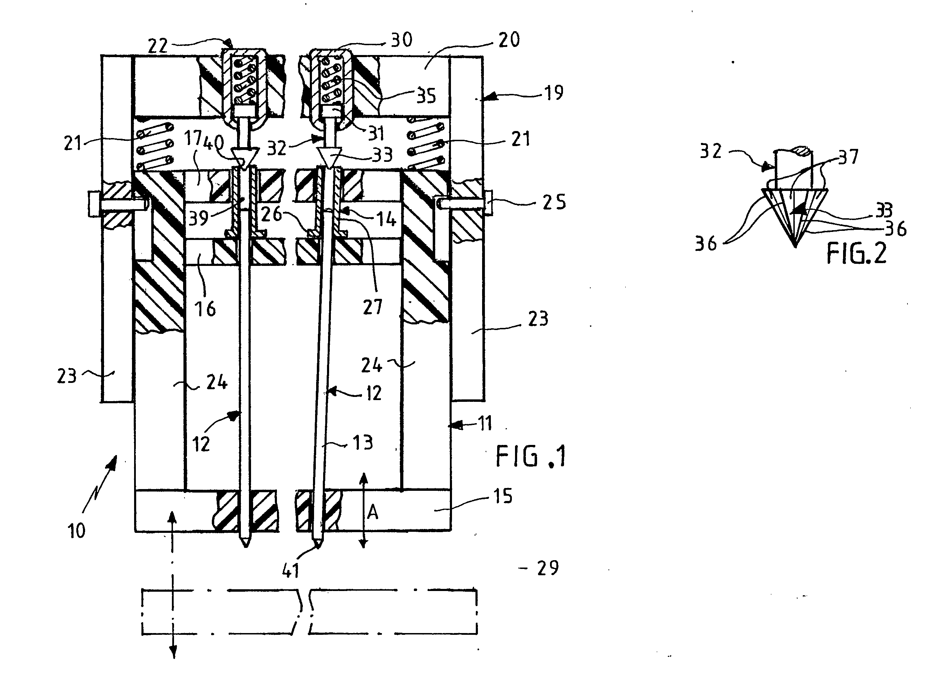

Die in Fig 1 dargestellte Kontaktiervorrichtung 10 bildet ein Teil einer nicht in weiteren Einzelheiten dargestellten Prüfeinrichtung zum Prüfen von Prüflingen 29, wie Leiterplatten, integrierten Schaltungen, Chips oder dergl. auf elektrische Fehlerfreiheit. Diese Kontaktiervorrichtung 10 weist eine Plattenanordnung 11 mit in sie eingesetzten metallischen Kontaktnadeln 12 auf. Jede Kontaktnadel 12 besteht aus einem massiven, geraden Stift 13 eines Durchmessers von bspw. 0,1 bis 1,4 mm und einer an dessen rückwärtigem Endbereich fest angeordneten, zu ihm koaxialen rohrförmigen Flanschhülse 14. Jede Kontaktnadel 12 ist in Bohrungen von drei zueinander parallelen Platten 15,16,17 der Plattenanordnung 11 beschränkt axial bewegbar geführt und gegen Herausfallen durch den Flansch 26 ihrer Flanschhülse 14 gesichert.

Diese Kontaktiervorrichtung 10 weist ferner eine starre Haltevorrichtung 19 auf, die eine als Träger für metallische Gegenkontaktelemente 22 dienende starre Platte 20 aufweist, relativ zu der die Plattenanordnung 11 mit den von ihr getragenen Kontaktnadeln 12 senkrecht zur Ebene dieser Platte 20 der Haltevorrichtung 19 gegen die Wirkung von Rückstellfedern 21 beweglich angeordnet ist. Die Plattenanordnung 11 kann sehr große Anzahlen von Kontaktnadeln 12 tragen, von denen nur zwei dargestellt sind.

Die Haltevorrichtung 19 weist an der Platte 20 befestigte Führungsschienen 23 zur Geradführung von Seitenträgern oder Längsträgern 24 der Plattenanordnung 11 auf, an welchen Trägern 24 die starren Platten 15,16,17 befestigt sind. Diese Plattenanordnung 11 ist auf diese Weise in Richtung des Doppelpfeiles A geradegeführt und gegen Drehen gesichert beweglich gelagert, wobei ihre Relativbewegung zur Haltevorrichtung 19 durch in Längsnuten der Führungsschienen 23 der Haltevorrichtung 19 eingreifende Anschlagstifte 25 begrenzt ist.

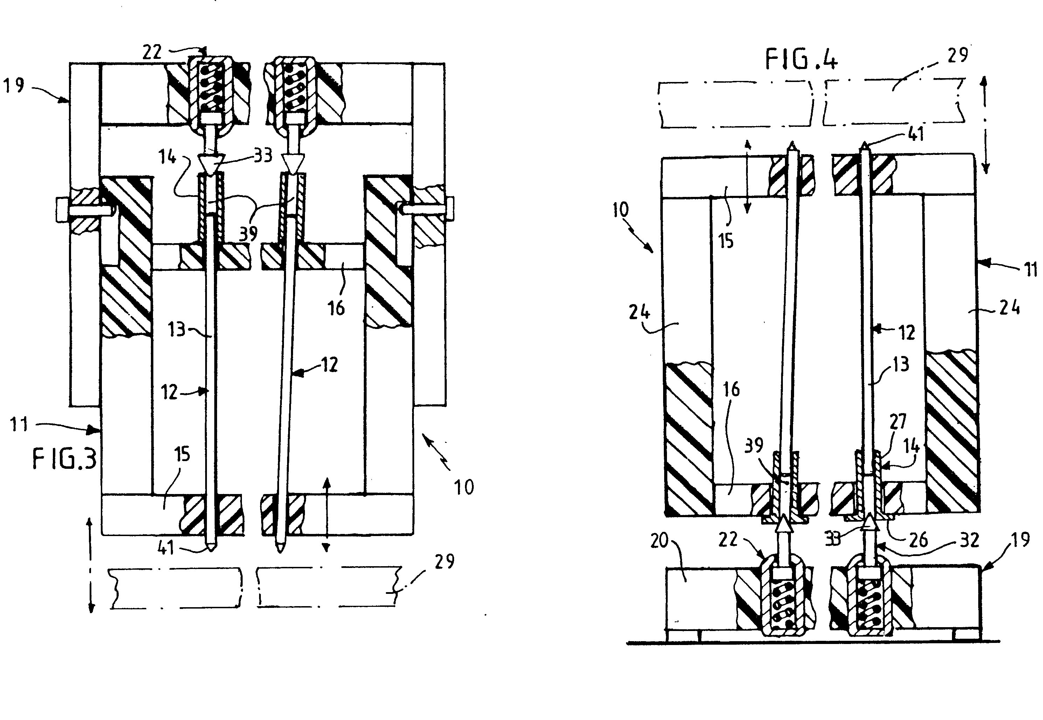

Die vorgespannten Druckfedern 21 bewirken, daß sich die Plattenanordnung 11, wenn sie nicht in Richtung auf die Gegenkontaktelemente 22 zu verschoben wird, sich in jeder Lage dieser Kontaktiervorrichtung 10 in ihrer dargestellten vordersten Stellung befindet, in der sie von der Platte 20 der Haltevorrichtung 19 maximalen Abstand hat. Dies können jedoch auch die Rückstellfedern 35 der Gegenkontaktelemente 22 bewirken, wenn sie, wie dargestellt, die Köpfe 33 ständig an die Hülsen 14 der Kontaktnadeln 12 andrücken und die Federn 21 können dann auch entfallen, wie es im Ausführungsbeispiel nach Fig. 3 dargestellt ist.

Da meist nicht allen Gegenkontaktelementen 22 Kontaktnadeln 12 zugeordnet sind, wie weiter unten noch erläutert wird, kann auch vorgesehen sein, daß Gegenkontaktelemente 22, denen momentan keine Kontaktnadeln 12 zugeordnet sind, an die Platte 17 ständig angedrückt sind und dann nur als Rückstellfedern für die Plattenanordnung 11 dienen.

Die beiden starren Träger 24 sind durch die im weiteren als erste rückwärtige Platte bezeichnete starre Platte 16 ständig fest und relativ zueinander unbeweglich verbunden. Diese erste rückwärtige Platte 16 dient gleichzeitig als vorderer Anschlag für die ebenen Ringflansche 26 der Flanschhülsen 14 der Kontaktnadeln 12, welche Flansche 26 sich hier an den der Platte 16 benachbarten vorderen Enden der Flanschhülsen 14 befinden.

An den beiden Trägern 24 ist ferner noch die als zweite rückwärtige Platte bezeichnete Platte 17 benachbart den Gegenkontaktelementen 22 fest angeordnet, durch deren betreffenden Bohrungen die kreiszylindrischen hohlen Schäfte 27 der Flanschhülsen 14 auch bei geringer Schrägstellung der Kontaktnadeln 12 von bspw. maximal 6˙ zur Bewegungsbahn A der Plattenanordnung 11 noch axial beweglich hindurchragen können.

Diese rückwärtige Platte 17 ist lösbar an den beiden zueinander parallelen Trägern 24 angeordnet. Ebenfalls lösbar ist an den beiden Trägern 24, und zwar an deren Stirnseiten die als vordere Platte bezeichnete Platte 15 der Plattenanordnung 11 fest angeordnet. Die ebenen Platten 15, 16 und 17 der Plattenanordnung 11 bestehen aus elektrisch isolierendem Kunststoff und ihre Ebenen erstrecken sich senkrecht zur Bewegungsbahn A der Plattenanordnung 11.

In manchen Fällen kann auch vorgesehen sein, die vordere Platte 15 in Richtung des Doppelpfeiles A an den Trägern 24 geradegeführt federnd beweglich anzuordnen, bspw. um einen Stoßpuffer beim Kontaktieren von Prüflingen, wie 29, zu bilden.

In den zylindrischen, vorzugsweise kreiszylindrischen Durchgangskanal der Flanschhülse, d.h. in den Innenraum der Flanschhülse 14 ist koaxial zu ihr der Stift 13 hier etwa bis zu einem Drittel der Länge dieses Innenraumes fest und formschlüssig eingesetzt und bspw. in einem Preßsitz oder sonstigem Festsitz und/oder auf sonstige Weise befestigt, vorzugsweise durch Schweißen, bspw. mittels eines mittels Laserschweißen erzeugten Schweißpunktes. Indem die Hülse 14 erheblich , bspw. 1 bis 3 mm, über den Stift 13 übersteht, bildet ein beträchtlicher Teil ihres Innenraumes einen zylindrischen, vorzugsweise kreiszylindrischen Hohlraum 39, der am rückwärtigen Ende der Flanschhülse 14 offen ist und diese Öffnung ist am rückwärtigen Ende vom Innenrand 40 der Wandung des Schaftes 27 umfasst. In diesem Hohlraum 39 kann sich zwar Schmutz etc. ansammeln, ohne den elektrischen Kontakt zwischen dem diesen Innenrand 40 kontaktierenden Kopf 33 des betreffenden Gegenkontaktelementes 22 und der Hülse 14 zu beeinträchtigen. Da der Hohlraum 39 nur zum Gegenkontaktelement 22 und nicht zu den Platten 15, 16 und 17 hin offen ist, kann in ihn jedoch kaum an diesen Platten entstehender Kunststoffabrieb gelangen. Auch ist dieser Hohlraum 39 durch den Kopf 33 praktisch abgedeckt. Es wird grösste Sicherheit erreicht, dass sich der elektrische Übergangswiderstand zwischen der Hülse 14 und dem betreffenden Kopf 33 auch nach langer Betriebszeit nicht störend erhöht.

Jeder Stift 13 ist mit Ausnahme seines vorderen, kegelförmig angespitzten Endes 41 kreiszylindrisch, also gerade, und im Betrieb verhält er sich starr, d.h. axial starr. Die Kontaktnadeln 12 kann man deshalb infolge ihres Betriebsverhaltens auch als starre Kontaktnadeln bezeichnen, obwohl sie selbstverständlich in ausgebautem Zustand auch aus ihren geraden Stellungen elastisch gebogen werden können. Diese Kontaktnadeln können bspw. aus hochlegiertem Stahl oder sonstigen abriebsfesten Metallen bestehen und bspw. auch mit Edelmetall beschichtet sein.

Das einzelne Gegenkontaktelement 22 ist in diesem Ausführungsbeispiel als Federkontaktstift ausgebildet, der eine metallische Hülse 30 aufweist, die fest in die Platte 20 der Haltevorrichtung 19 eingesetzt ist. In dieser Hülse 30 befindet sich der Kolben 31 eines zur Längsachse der Hülse 30 koaxialen metallischen Kolbengliedes 32. Das Kolbenglied 32 weist außer dem Kolben 31 einen an ihn koaxialen, einstückig anschließenden Schaft 34 und den an diesen Schaft 34 einstückig oder an ihn fest angesetzten Kopf 33 auf. Dieser Kopf 33 ist in diesem Ausführungsbeispiel an seinem rückwärtigen Ende im Durchmesser größer als der Schaft 34. Er kann in manchen Fällen jedoch auch als ein sich verjüngendes Ende des Schaftes 34 ausgebildet sein. Auch ist der Durchmesser des Kopfes 33 am rückseitigen Ende größer als der des Schaftes 27 und damit auch des Durchmessers des Innenrandes 40 der Hülse 14.

Der Kopf 33 verjüngt sich in diesem Ausführungsbeispiel von seinem Bereich größten Durchmessers kegelförmig in Richtung auf die Flanschhülse 14 der zugeordneten Kontaktnadel 12 und kontaktiert den ihm zugewendeten Innenrand 40 des rückwärtigen Endes der Wandung der Flanschhülse 14, indem eine in der Hülse 30 des Gegenkontaktelementes 22 angeordnete, vorgespannte metallische Druckfeder 35 das Kolbenglied 32 bis zum Inkontaktkommen seines Kopfes 33 mit dem Innenrand 40 der betreffenden Flanschhülse 14 drückt und so der Hohlraum 39 ständig "abgesperrt" ist und in ihn überhaupt kein Schmutz eindringen kann. Es kann ggf. auch vorgesehen sein, daß das Gegenkontaktelement 22 so angeordnet ist, daß in der dargestellten Stellung der betreffenden Kontaktnadel 12 sich der Kopf 33 des Kolbengliedes 32 noch im Abstand von der betreffenden Flanschhülse 14 befindet und erst beim Kontaktieren von Prüflingen 29 der Kontakt zwischen der Flanschhülse 14 und dem betreffenden Kopf 33 zustande kommt.

Man kann auch vorsehen, die Kontaktiervorrichtung 10 so anzuordnen, daß die Kontaktnadelspitzen 41 nach oben gerichtet und die Köpfe 33 etwas zurückversetzt sind, damit sich in der Ruhestellung der Plattenanordnung 11 die Flansche 26 im Abstand von beiden Platten 16 und 17 zwischen ihnen befinden oder auf der Platte 17 aufliegen und man kann dann bspw. die Kontaktnadeln 12 so lang vorsehen, daß ihre Spitzen 41 dabei nicht mehr über die Platte 15 überstehen. Auch kann man, wenn man die Kontaktiervorrichtung 10 mit nach oben gerichteten Spitzen 41 der Kontaktnadeln 12 für den Betrieb anordnet, die Führungsschienen 23 weglassen, da die Gegenkontaktelemente 22 die Plattenanordnung in Richtung des Doppelpfeiles A tragen und beweglich geradeführen und auch die erforderliche Zentrierung herbeiführen, wie es das Ausführungsbeispiel nach Fig. 4 zeigt.

Die spitzen vorderen Enden 41 der Stifte 13 der Kontaktnadeln 12 stehen in dem Ausführungsbeispiel nach Fig. 1 über die vordere Platte 15 über. Die Kontaktnadeln 12 sind in den Bohrungen der Platten 15,16 und 17, in denen sie sich befinden, mit Gleitlagerspiel axial beweglich gelagert und geführt.

Der Flansch 26 jeder Flanschhülse 14 liegt in diesem Ausführungsbeispiel bei der durch keinen Prüfling 29 belasteten Ruhestellung der Plattenanordnung 11 an der ersten rückwärtigen Platte 16 an.

Wenn ein Prüfling 29 zu seinem elektrischen Anschluß an ein nicht dargestelltes Testgerät einer diese Kontaktiervorrichtung 10 aufweisenden Prüfeinrichtung an die Kontaktnadelspitzen 41 angedrückt wird, dann kommt er nach kurzem Weg an die vordere Platte 15 zur Anlage, wobei sich schon vorher die Flansche 26 von der Platte 16 abgehoben haben und drückt jetzt auch die Plattenanordnung 11 auf die Platte 20 zu. Es werden beim Bewegen der Kontaktnadeln 12 die Kolbenglieder 32 der von Hülsen 14 kontaktierten Gegenkontaktelemente 22 durch die Kontaktnadeln 12 gegen die Wirkung der Rückstellfedern 35 weiter in die Hülsen 30 hinein bewegt, da sich der Abstand zwischen dem Prüfling 29 und der Platte 20 verringert und hierdurch über die Rückstellfedern 35 ansteigende Federkräfte auf die Flanschhülsen 14 und damit auf die Kontaktnadeln 12 und deren vorderen Spitzen 41 auf die betreffenden Stellen des Prüflinges 29 aus.

Die Kraft jeder Feder 35 überträgt sich dabei wegen der geringen Gleitreibung der betreffenden Kontaktnadel 12 in den sie führenden Bohrungen der Platten 15, 16 und 17 in praktisch voller Größe auf den Prüfling 29 über die Spitze 41 der betreffenden Kontaktnadel 12. Hierdurch tritt sicherer elektrischer Kontakt zwischen den Kontaktnadeln 12 und den von ihnen kontaktierten Stellen des jeweiligen Prüflings 29 ein, desgleichen sicherer elektrischer Kontakt zwischen den Köpfen 33 und den von ihnen kontaktierten Flanschhülsen 14.

Sobald die Plattenanordnung 11 den vorgesehenen geringsten Abstand von der Platte 20 der Haltevorrichtung 19 erreicht hat, wird mittels des Testgerätes die elektrische Prüfung des betreffenden, bspw. eine Leiterplatte bildenden Prüflings 29 durchgeführt, wobei die Kontaktnadeln 12 und die von ihnen kontaktierten Gegenkontaktelemente 22 als elektrische Leiter mitwirken, indem sie zusammen mit sie mit dem Testgerät verbindenden elektrischen Leitungen die für die Prüfung erforderlichen elektrischen Verbindungen zwischen dem Prüfling 29 und dem Testgerät der Prüfeinrichtung herstellen. Wenn das Testgerät die Prüfung des elektrischen oder elektronischen Prüflings 29 durchgeführt hat, wird der Prüfling 29 von der Kontaktiervorrichtung 10 wieder weggeführt und ein neuer, gleicher Prüfling wird dann an seiner Stelle in derselben Weise durch die Kontaktiervorrichtung kontaktiert und durch das Testgerät auf elektrische Fehlerfreiheit geprüft.

In diesem Ausführungsbeispiel nach Fig. 1 ist die Plattenanordnung 11 so ausgebildet, daß auch bei abgenommener Haltevorrichtung 19 aus ihr die in sie eingesetzten Kontaktnadeln 12 infolge deren zwischen den beiden rückwärtigen Platten 16,17 angeordneten Flansche 26 nicht herausfallen können, da beide rückwärtigen Platten Anschläge für diese Flansche 26 bilden, so daß also diese Flansche 26 die axiale Beweglichkeit der Kontaktnadeln 12 im Zusammenwirken mit den beiden rückwärtigen Platten 16,17 begrenzen. Diese Plattenanordnung 11 mit den Kontaktnadeln 12 kann also für sich in beliebigen Lagen transportiert oder angeordnet werden, d.h., man braucht deshalb auch dann, wenn sie noch nicht an der Haltevorrichtung 19 angebracht ist, nicht auf die Lage dieser die Kontaktnadeln 12 tragenden Plattenanordnung 11 zu achten, da die Kontaktnadeln aus ihr nicht herausfallen können.

Wenn hierauf verzichtet wird, kann man auch gemäß den Ausführungsbeispielen nach den Fig. 3 und 4 vorsehen, nur eine einzige rückwärtige Platte 16 vorzusehen, die bei der noch zu beschreibenden Montage der Kontaktnadeln 12 einen Anschlag für deren Hülsen 14 bildet.

Im Falle der Kontaktiervorrichtung 10 nach Fig. 3 ist die an dem Stift 13 der jeweiligen Kontaktnadel 12 koaxial befestigte Hülse 14 nur als kreiszylindrisches Rohr ausgebildet, deren der rückwärtigen Platte 16 benachbarten Stirnseite dem Inanschlagkommen mit dieser Platte 16 dient, da der Außendurchmesser der Hülse 14 größer als der Durchmesser der von der betreffenden Kontaktnadel 12 mit ausreichendem Gleitlagerspiel durchdrungenen Bohrung dieser einzigen rückwärtigen Platte 16 ist.

Bei der Ausführungsform nach Fig. 4 ist dagegen die rohrförmige Hülse 14 wiederum als Flanschhülse ausgebildet, wobei hier jedoch ihr Flansch 26 an dem dem Gegenkontaktelement 22 benachbarten Ende der Flanschhülse 14 angeordnet ist und in der dargestellten Ruhestellung der Plattenanordnung 11 an der den Gegenkontaktelementen 22 benachbarten Seite der einzigen rückwärtigen Platte 16 anliegt.

Jede der Plattenanordnungen 11 nach den Fig. 3 und 4 muss nach Einsetzen der Kontaktnadeln 12, solange diese Plattenanordnung 11 noch nicht an der zugeordneten Haltevorrichtung 19 angeordnet ist, in solchen Stellungen belassen werden, daß die eingesetzten Kontaktnadeln 12 aus ihr nicht herausfallen können. Oder man kann auch bspw. für den Transport vorsehen, an der Plattenanordnung 11 eine das Herausfallen der Kontaktnadeln 12 verhindernde rückwärtige Abdeckung oder dgl. provisorisch anzubringen und sie vor Anbringen der Haltevorrichtung 19 wieder abzunehmen. Sobald die Haltevorrichtung 19 an der Plattenanordnung 11 angeordnet ist, verhindern die federbelasteten Kolbenglieder 32 der Gegenkontaktelemente 22 das Herausfallen der Kontaktnadeln 12, wie man aus Fig. 3 und 4 ohne weiteres ersieht.

In dem Ausführungsbeispiel nach Fig. 1 kann zweckmäßig vorgesehen sein, daß beide rückwärtigen Platten 16,17 der Plattenanordnung 11 und in den Ausführungsbeispielen nach Fig. 3 und 4 die rückwärtige Platte 16 der Aufnahme von Kontaktnadeln 12 dienende Bohrungen aufweisen, die an Rasterpunkten eines vorbestimmten Rasters angeordnet sind. Der Raster kann bspw. ein 1/10 Zoll-Raster oder ein sonstiger geeigneter Raster mit kleinem Rastermaß sein. Wenn dabei, wie bevorzugt vorgesehen ist, die vordere Platte 15 der Plattenanordnung 11 auch für Kontaktnadeln 12 bestimmte Bohrungen aufweisen kann, die nicht in dem betreffenden Raster liegen, gemäß dem die Bohrungen der rückwärtigen Platten 16,17 bzw. 16 gebohrt sind, nämlich um auch außer dem Raster liegende, zu kontaktierende Stellen des jeweiligen Prüflinges 29 mittels Kontaktnadeln 12 kontaktieren zu können, dann ist es notwendig, daß hierzu die betreffende Kontaktnadel 12 in den sie aufnehmenden, miteinander fluchtenden Bohrungen der Platten 16,17 (Fig .1) bzw. der Platte 16 (Fig.3, 4) und der Platte 15 ausreichendes Gleitlagerspiel hat, um die erforderliche geringe Schrägstellung der Kontaktnadel 12 relativ zu den Längsachsen der Bohrungen der Platten 15,16,17, bzw. 15,16 der Plattenanordnung 11 zuzulassen. Hierfür ist nur relativ geringes Spiel erforderlich, weil die auftretenden Schrägstellungen im Hinblick auf die kleinen Rastermaße und im Falle der Fig. 1 die relativ geringen Abstände der beiden rückwärtigen Platten 16,17 von normalerweise einigen Millimetern voneinander im Vergleich zu der viel größere Länge der Kontaktnadeln 12, die bspw. 2 bis 12 cm betragen kann, nur gering ist, bspw. maximal 6° zu den Längsachsen der Bohrungen der Platten 15,16,17 betragen kann.

Gewünschtenfalls kann auch vorgesehen sein, daß die Bohrungen der den Kontaktelementen benachbarten rückwärtigen Platte 16 bzw. 17 an Stellen, wo es erwünscht oder zweckmäßig ist, ebenfalls außer dem Raster liegend gebohrt sein können, derart, daß das für die Schrägstellung der betreffenden Kontaktnadeln in ihnen erforderliche Spiel kleiner vorgesehen sein kann. Die betreffende Platte 16 bzw. 17 ist dann ebenfalls auf nur eine Sorte von Prüflingen abgestimmt und bei Sortenwechsel entsprechend auszuwechseln.

Bei den Plattenanordnungen 11 nach den Fig. 1,3 und 4 ist es besonders zweckmäßig, vorzusehen, daß jede rückwärtige Platte 16 bzw. 17, deren Bohrungen im betreffenden Raster gebohrt sind, im vorgesehenen Feld an allen Rasterpunkten des Rasters Bohrungen für Kontaktnadeln 12 aufweist, gleichgültig, wieviele dieser Bohrungen jeweils mit Kontaktnadeln besetzt werden, um diese Platten nicht auswechseln zu müssen. Die vordere Platte 15 kann dagegen, wenn sie außer dem Raster liegende Bohrungen für Kontaktnadeln 12 enthält, zweckmäßig für Prüflinge einer Sorte individuell hergestellt werden und wird nur dann an den Trägern 24 angebracht, wenn Prüflinge der ihr zugeordneten Sorte geprüft werden. Wenn eine andere Sorte von Prüflingen zu prüfen ist, wird diese vordere Platte 15 dann gegen eine den Prüflingen der anderen Sorte individuell angepasste vordere Platte 15 mit also entsprechend anders angeordneten Bohrungen ausgetauscht.

Die Anzahl der Bohrungen der vorderen Platte 15 braucht ferner nur der Anzahl der durch Kontaktnadeln 12 zu kontaktierenden Stellen der betreffenden Prüflingssorte zu entsprechen und bei der Bestückung der Plattenanordnung 11 mit Kontaktnadeln 12 wird dann in sie nur eine der Anzahl der Bohrungen der vorderen Platte 15 entsprechenden Anzahl von Kontaktnadeln 12 eingesetzt.

Die Gegenkontakte 22 in der Platte 20 der Haltevorrichtung 19 können ebenfalls in dem betreffenden Raster angeordnet sein, wobei zweckmäßig an jedem Punkt dieses Rasters im betreffenden Feld ein Kontaktelement 22 ständig angeordnet sein kann. Es genügt dann bei einem Wechsel der Sorte der Prüflinge nur die Plattenanordnung 11 mit einer angepassten vorderen Platte 15 zu versehen und neu mit Kontaktnadeln 12 zu bestücken, und die Haltevorrichtung 19 kann für alle Sorten von Prüflingen unverändert bleiben, indem bspw. jeweils nur die Gegenkontaktelemente 22 an das Testgerät prüfwirksam angeschaltet oder angeschlossen werden, die mit als elektrische Leiter zu dienen haben.

Die Bestückung der Plattenanordnungen 11 der Fig. 1,3 und 4 kann zweckmäßig wie folgt vorgenommen werden.

Die jeweilige Plattenanordnung 11 wird von der Haltevorrichtung 19 abgenommen. Im Falle der Fig. 1 wird danach die zweite rückwärtige Platte 17 von den Trägern 24 abgenommen. Bei den Fig. 3 und 4 entfällt diese Arbeit. Die bisherigen Kontaktnadeln werden entfernt und können für die neue Bestückung wieder verwendet oder mitverwendet werden. Die bisherige Frontplatte 15 wird abgenommen und die neue Frontplatte 15 wird an die Stirnseiten der Träger 24 in horizontaler Stellung angelegt, jedoch noch nicht mit ihnen fest verbunden, oder an eine andere Führung angelegt oder auf sonstige Weise getragen und mittels einer nicht dargestellten motorischen Stellvorrichtung kann sie horizontal senkrecht und parallel zur Bildebene oder sonstwie parallel zu sich selbst verfahren, d.h.verschoben werden.Diese Stellvorrichtung kann selbsttätig gemäß einem vorbestimmten Programm von einem Rechner gesteuert werden. Eine vorzugsweise ebenfalls selbsttätig arbeitende, bspw. von dem Rechner mit gesteuerte Bestückungsvorrichtung für die Kontaktnadeln 12 kann nacheinander je eine Kontaktnadel 12 in eine vorbestimmte Bohrung der rückwärtigen Platte 16 vertikal einsetzen. Dabei ist die vordere Platte 15 so lageeingestellt worden, daß ihre für diese Kontaktnadel 12 vorgesehene Bohrung mit der betreffenden Bohrung der rückwärtigen Platte 16 vertikal fluchtet, so daß diese Kontaktnadel 12 nur durch axiale vertikale Bewegung zuerst in die zugeordnete Bohrung der rückwärtigen Platte 16 und dann durch weiteres vertikales motorisches Abwärtsbewegen oder im freien Fall in die zugeordnete Bohrung der vorderen Platte 15 eingesetzt werden kann. Spätestens nach ihrer Freigabe kommt dann diese Kontaktnadel 12 im Falle der Fig. 1 und 4 mit dem Flansch 26 ihrer Flanschhülse 14 bzw. im Falle der Fig. 3 mit der vorderen (unteren) Stirnseite ihrer Hülse zur Anlage an die Oberseite der rückwärtigen Platte 16. Diese Platte 16 ist also hierbei horizontal ausgerichtet, so daß ihre Bohrungen vertikal verlaufen, desgleichen die Bohrungen der vorderen Platte 15. Dann wird die nächste Kontaktnadel mit in die ihr zugeordneten Bohrungen der rückwärtigen Platte 16 und der vorderen Platte 15 eingesetzt, nachdem erforderlichenfalls auch hier vor ihrem Einsetzen in die betreffende Bohrung der vorderen Platte 15 diese Bohrung in Fluchtung mit der zugeordneten Bohrung der rückwärtigen Platte 16 selbsttätig gebracht wurde.

Wenn alle vorgesehenen Kontaktnadeln 12 auf diese Weise in die rückwärtige Platte 16 und in die vordere Platte 15 eingesetzt sind, wird im Falle der Fig. 1 die zweite rückwärtige Platte 17 angebracht. Die betreffende Plattenanordnung 11 wird dann in allen Ausführungsbeispielen nach den Fig. 1,3 und 4 an der zugeordneten Haltevorrichtung 19 angeordnet. Im Falle der Fig.4 braucht sie nur auf die Köpfe 33 der Gegenkontaktelemente 22 aufgesetzt zu werden.

Wenn ein Sortenwechsel der Prüflinge stattfindet, wird diese Kontaktiervorrichtung wieder durch Abnahme der Haltevorrichtung und ggf. der zweiten rückwärtigen Platte 17 und der vorderen Platte 15 und Abnahme der Kontaktnadeln 12 teilweise demontiert und dann eine andere, der neuen Sorte von Prüflingen angepaßte vordere Platte 15 an der Montagevorrichtung angeordnet und die rückwärtige Platte 16 und die vordere Platte 15 werden dann mit Kontaktnadeln 12 neu bestückt.

In Fig. 2 ist eine Abwandlung des Kopfes 33 des Kolbengliedes 32 eines Gegenkontaktelementes 22 dargestellt. Dieser Kopf 33 weist äußere, scharfkantig angeschliffene, durch Nuten 37 dreieckförmiger Querschnitte voneinander getrennte Längskanten 36 auf; die Mantellinien eines geometrischen Kegelmantels sind, der koaxial zur Längsachse des Kolbengliedes 32 ist. Hierdurch wird besonders guter elektrischer Kontakt zwischen diesem Kopf 33 und dem Innenrand 40 der jeweils zugeordneten Hülse 14 der betreffenden Kontaktnadel 12 erreicht.

Es können, falls erwünscht, zwischen den Platten 15 und 16 der Plattenanordnungen 11 noch eine oder mehrere zu diesen Platten 15,16 parallele Platten als Knickschutz für die Kontaktnadeln 12 angeordnet sein, wenn diese so dünn sind, daß Knickgefahr besteht.

Zwar ist es besonders vorteilhaft, die Plattenanordnung 11 relativ zur Haltevorrichtung 19 beweglich anzuordnen, da hierdurch der Überstand der Spitzen 41 der Kontaktnadeln 12 über die vordere Platte klein gehalten oder sogar vermieden werden kann, was besonders günstig im Fall schräg angeordneter Kontaktnadeln 12 ist, um besonders genaue Führung bis zum Zielpunkt auf dem Prüfling 29 zu gewährleisten. Doch kann in manchen Fällen auch vorgesehen sein, den Überstand der Spitzen 41 der Kontaktnadeln 12 über die vordere Platte 15 so groß vorzusehen, daß man die Plattenanordnung 11 mit der Haltevorrichtung 19 unbeweglich verbinden kann.

Die Flansche 26 der Hülsen 14 kann man auch als Anschläge bezeichnen.

Wenn die Kontaktiervorrichtung nach Fig. 1 in nicht dargestellter Weise so abgewandelt ist, daß in der Ruhestellung der Plattenanordnung 11 sich die Flansche 26 der Hülsen 14 der Kontaktnadeln 12 im Abstand von beiden rückwärtigen Platten 16,17 befinden und sie auch beim Prüfen von Prüflingen nicht zum Anschlag an diese Platten 16,17 kommen, dann bilden diese Flansche 26 nur beim beschriebenen Bestücken der Plattenanordnung mit Kontaktnadeln 12 Anschläge, die zum Anschlag an die Platte 16 kommen, die dann ihrerseits eine Anschlagplatte für sie nur beim beschriebenen Bestücken bildet. Wenn die Bestückung der Plattenanordnung 11 jedoch so vorgenommen wird, daß die Flansche 27 auch bei ihr nicht an die Platte 16 zum Anschlag kommen, dann kann man diese Flansche 16 auch weglassen, so daß die Hülsen 14 dann nur dem Kontaktieren der Köpfe 33 dienen.

## Ansprüche

1. Kontaktiervorrichtung für Prüfeinrichtungen zum Prüfen von elektrischen oder elektronischen Prüflingen, wie Leiterplatten, integrierten Schaltkreisen, Chips oder dgl., welche Kontaktiervorrichtung eine Plattenanordnung aus mehreren zueinander parallelen Platten aufweist, die Löcher aufweisen, in die dem Kontaktieren von Prüflingen dienende metallische, gerade, beim Kontaktieren von Prüflingen im wesentlichen axial belastete Kontaktnadeln eingesetzt sind, wobei jeder Kontaktnadel ein federndes, elektrisch leitendes Gegenkontaktelement zu ihrem elektrischen Anschluß und zur Ausübung von Federkräften auf sie zugeordnet ist, welche Gegenkontaktelemente gegenüber den rückwärtigen Enden der Kontaktnadeln an einer Haltevorrichtung angeordnet sind, relativ zu der die Kontaktnadeln in ihren Längsrichtungen beweglich sind, dadurch gekennzeichnet, daß jede Kontaktnadel (12) aus einem geraden Stift (13) und einer auf dem Stift zu ihm koaxial fest angeordneten geraden, rohrförmigen Hülse (14) besteht, welche Hülse über das rückwärtige Ende des Stiftes zur Schaffung eines am rückwärtigen Ende der Kontaktnadel offenen, durch den Innenraum der Hülse gebildeten Hohlraumes (39) übersteht, daß die Kontaktnadeln in den Bohrungen der Platten (15,16,17; 15,16) der Plattenanordnung (11) mit solchem Spiel angeordnet sind, daß sie sich in diesen Bohrungen axial bewegen können, und daß die Gegenkontaktelemente (22) dem Kontaktieren der ihnen zugewandten rückwärtigen Innenränder (40) der Hülsen (14) der Kontaktnadeln (12) dienende, sich in Richtung auf die Stifte der Kontaktnadeln zu verjüngende Köpfe (33) aufweisen.

2. Kontaktiervorrichtung nach Anspruch 1, dadurch gekennzeichnet, daß die Hülse (14) der Kontaktnadel mindestens eine vorzugsweise einen Anschlag bildende Verbreiterung, vorzugsweise einen endseitigen Flansch (26), aufweist, und/oder daß mindestens eine rückwärtige Platte (16,17;16) der Plattenanordnung (11) als Anschlag für die Hülsen (14) der 'Kontaktnadeln (12) dienen kann, vorzugsweise bei dem Bestücken der Plattenanordnung mit Kontaktnadeln und/oder bei der fertig montierten Kontaktiervorrichtung.

3. Kontaktiervorrichtung nach Anspruch 2, dadurch gekennzeichnet, daß die Plattenanordnung (11) zu beiden Seiten der Verbreiterungen (26) der Hülsen (14) der Kontaktnadeln (12) je eine vorzugsweise als Anschlag für diese Verbreiterungen (26) dienende erste und zweite rückwärtige Platte (16,17) aufweist, die der Begrenzung der axialen Beweglichkeit der Kontaktnadeln in ihren beiden axialen Bewegungsrichtungen dienen können.

4. Kontaktiervorrichtung nach Anspruch 3, dadurch gekennzeichnet, daß die Plattenanordnung (11) insgesamt drei Platten (15,16,17) mit Bohrungen für die Kontaktnadeln aufweist,welche Platten vorzugsweise relativ zueinander unbeweglich angeordnet sind.

5. Kontaktiervorrichtung nach einem der Ansprüche 1 bis 3, dadurch gekennzeichnet, daß die Plattenanordnung insgesamt zwei Platten (15,16) mit Bohrungen für die Kontaktnadeln aufweist, nämlich eine vordere Platte (15) und eine rückwärtige Platte (16), und daß die Gegenkontaktelemente (22) auch der Sicherung der Kontaktnadeln gegen Herausfallen aus der Plattenanordnung in der axialen Richtung dienen, die entgegengesetzt zu der axialen Richtung ist, in der die Hülsen der Kontaktnadeln zum Anschlag an die rückwärtige Platte kommen können.

6. Kontaktiervorrichtung nach einem der vorhergehenden Ansprüche, dadurch gekennzeichnet, daß der Kopf (33) des Gegenkontaktelementes (22) eine Mehrzahl von scharfen Außenkanten (36) aufweist, die sich vorzugsweise entlang von Mantellinien eines geometrischen Kegels erstrecken, und die dem Kontaktieren des rückwärtigen Innenrandes (40) der Hülse der zugeordneten Kontaktnadel dienen.

7. Kontaktiervorrichtung nach einem der vorhergehenden Ansprüche, dadurch gekennzeichnet, daß das Gegenkontaktelement ein Federkontaktstift (22) ist.

8. Kontaktiervorrichtung nach einem der vorhergehenden Ansprüche, dadurch gekennzeichnet, daß die Hülse (14) mit dem Stift (13) der Kontaktnadel verschweißt ist.

9. Kontaktiervorrichtung nach einem der Ansprüche 2 bis 8, dadurch gekennzeichnet, daß die Verbreiterung (26) der Hülse (14) sich an ihrem dem vorderen Ende (41) der Kontaktnadel (12) benachbarten Ende der Hülse befindet.

10. Kontaktiervorrichtung nach einem der vorhergehenden Ansprüche, dadurch gekennzeichnet, daß die Plattenanordnung (11) in relativ zu der Ebene ihrer vorderen Platte (15) senkrechter Richtung relativ zu der Haltevorrichtung (19) geradegeführt beweglich und vorzugsweise in von der Haltevorrichtung (19) wegführender Richtung federbelastet ist, wobei die Geradführung der Plattenanordnung (11) vorzugsweise allein durch die Gegenkontaktelemente (22) bewirkbar ist.

11. Kontaktiervorrichtung nach einem der vorhergehenden Ansprüche, dadurch gekennzeichnet, daß die Bohrungen für die Kontaktnadeln der vorderen Platte (15) der Plattenanordnung (11) entsprechend den durch die Kontaktnadeln zu kontaktierenden Stellen des betreffenden Prüflinges (29) angeordnet sind und daß die Bohrungen für die Kontaktnadeln in der rückwärtigen Platte (16) oder mindestens einer der rückwärtigen Platten (16,17) der Plattenanordnung gemäß einem vorbestimmten Raster angeordnet sind.

12. Kontaktiervorrichtung nach einem der vorhergehenden Ansprüche, dadurch gekennzeichnet, daß die Kontaktnadeln sich im Betrieb der Kontaktiervorrichtung als starre Kontaktnadeln (12) verhalten.

13. Verfahren zum Bestücken einer Kontaktiervorrichtung nach einem der vorhergehenden Ansprüche mit Kontaktnadeln, dadurch gekennzeichnet, daß die Kontaktnadeln nacheinander in zwei Platten der Plattenanordnung so eingesetzt werden, daß jede Kontaktnadel zuerst in die der vorderen Platte benachbarte rückwärtige Platte und von ihr aus in die vordere Platte der Plattenanordnung eingesetzt wird, wobei die Bohrungen für die Kontaktnadeln in der der vorderen Platte benachbarten rückwärtigen Platte der Plattenanordnung gemäß einem vorbestimmten Raster angeordnet sind und daß immer dann , wenn mindestens eine Bohrung der vorderen Platte nicht in diesem Raster angeordnet ist, für das Einsetzen der betreffenden Kontaktnadel in die ihr zugeordneten Bohrungen diese in Fluchtung miteinander gebracht und später wieder außer Fluchtung gebracht werden.

14. Verfahren nach Anspruch 13, dadurch gekennzeichnet, daß im Falle von zwei rückwärtigen Platten der Plattenanordnung, zwischen denen die Verbreiterungen der Hülsen der Kontaktnadeln anzuordnen sind, die hintere Platte der beiden rückwärtigen Platten erst dann auf die Hülsen der Kontaktnadeln aufgesteckt wird, nachdem alle Kontaktnadeln in die der vorderen Platte der Plattenanordnung benachbarte rückwärtige Platte und in diese vordere Platte eingesetzt sind.

EP 0 331 163 A1

FIG .1

FIG.2

- 29

FIG.4

FIG.3

6053

| | **EINSCHLÄGIGE DOKUMENTE** | | EP 89103653.5 |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl. 4) |
| D,X | <u>EP - A1 - 0 215 146</u> (MANIA) * Fig. 6 * -- ------ | 1 | G 01 R 1/073 |
| | | | RECHERCHIERTE SACHGEBIETE (Int. Cl.⁴) |
| | | | G 01 R 1/00 G 01 R 31/00 |

Der vorliegende Recherchenbericht wurde für alle Patentansprüche erstellt.

| Recherchenort | Abschlußdatum der Recherche | Prüfer |
|---|---|---|
| WIEN | 29-05-1989 | KUNZE |